# EUROPEAN PATENT APPLICATION

(11) **EP 4 333 028 A1**
(43) Date of publication of application: **06.03.2024**
(21) Application number: 23194930.6
(22) Date of filing: 01.09.2023
(51) Int. Cl.: H01L 21/48, H01L 23/15, H01L 23/498

(54) **METHOD FOR FORMING THROUGH-VIA METAL WIRING**

(30) Priority: 01.09.2022 KR 20220110885
(71) Applicant: Extol Co., Ltd., Gyeonggi-do 15657 (KR)
(72) Inventor: KIM, Sung Woong, 16555 Suwon-si (KR); HUR, Wook Hwan, 15483 Ansan-si (KR); KIM, Nam-jin, 15594 Ansan-si (KR); NA, Yong-chae, 15459 Ansan-si (KR)
(74) Representative: V.O.

(57) **Abstract**

The present invention relates to a method for forming through-via metal wiring, and according to the method of the present invention, through-via metal wiring can be formed with excellent plating quality without an expensive sputtering process by bonding a metal foil to one side of a substrate having a through-via formed therein and using the foil as a metal seed layer.

## Description

### [Technical Field]

The present invention relates to a method for forming through-via metal wiring. Particularly the present invention relates to a method for forming through-via metal wiring with excellent plating quality without an expensive sputtering process.

### [Background Art]

Glass is a popular material for many electronic devices such as displays, interposers, sensors, and the like. These electronic devices may include vias extending through the thickness of the glass substrate to transmit electrical signals from one major surface of the glass substrate to another major surface of the glass substrate. The vias can be filled with metal to form through-glass via (TGV) metal wiring in the glass substrate. Such through-glass via metal wiring can carry electrical signals and power between circuitry located on top of the glass substrate and circuitry located on the bottom of the glass substrate.

Glass substrates with through-glass via metal wiring are widely used as interposers, for example, in large-scale integration (LSI) mounting technologies. An interposer is a type of electronic component that creates vias in a substrate for placing or mounting chips on the substrate, connecting chips to each other and chips to a printed circuit board (PCB). Traditionally, silicon has been used as the substrate material for interposers, but it has recently been replaced by glass because it is electrically nonconductive and inexpensive.

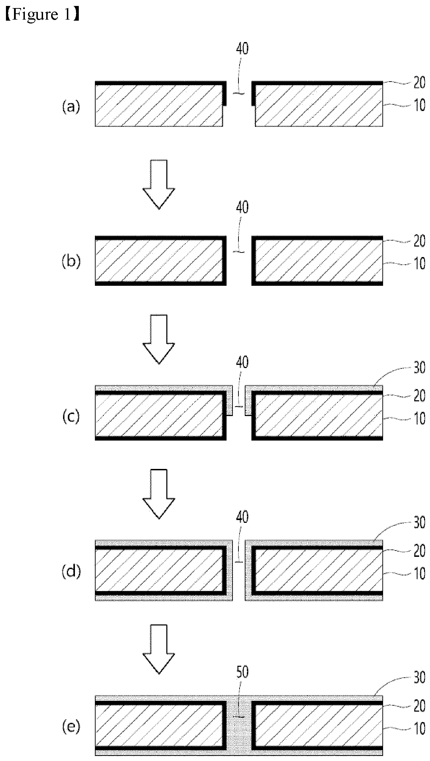

A conventional method for forming through-via metal wiring on a glass substrate is shown in FIG. 1. First, titanium (Ti) sputtering is performed on both surfaces of the glass substrate 10, respectively, to form a titanium metal layer 20 on both surfaces of the glass substrate and the sidewalls of the via hole 40. Then, copper (Cu) sputtering is performed on both surfaces of the glass substrate, respectively, to form a copper seed layer 30 on the titanium metal layer, and electrolytic or electroless plating is performed to fill the via hole to form through-via metal wiring 50.

However, this method of forming through-via metal wiring has the disadvantage of requiring an expensive sputtering process and a complex process. In addition, depending on the aspect ratio of the via hole, the hole size, and the composition of the plating solution, gap defects (voids) or boundary defects (seams) may be formed in the via hole, causing deterioration of the electrical characteristics or reliability of the device package.

Therefore, there is a need to develop a method for forming through-via metal wiring with excellent plating quality without the need for an expensive sputtering process.

### [Disclosure of Invention]

### [Technical Problem]

An object of the present invention is to provide a method for forming through-via metal wiring with excellent plating quality without an expensive sputtering process.

### [Technical Solution]

An aspect of the present invention provides a method for forming through-via metal wiring including:
(i) bonding a metal foil to one side of a substrate having a through-via formed therein with an adhesive layer;
(ii) treating a hole formed by the through-via and the metal foil with a plasma to remove the adhesive layer located inside the hole;
(iii) filling the hole with metal by a plating process; and
(iv) removing the metal foil and the adhesive layer with an etchant.

The method for forming through-via metal wiring according to an embodiment of the present invention may further include (v) washing the substrate, after the step (iv).

In an embodiment of the present invention, the substrate may be a glass substrate, a silicon substrate, or a ceramic substrate.

In an embodiment of the present invention, the metal foil may be a copper foil.

In an embodiment of the present invention, the metal foil may have a thickness of 3 to 1,000 µm.

In an embodiment of the present invention, the adhesive layer may be formed from one or more selected from the group consisting of an acrylic-based adhesive, a silicone-based adhesive, a polyurethane-based adhesive, and a rubber-based adhesive.

In an embodiment of the present invention, the plasma treatment in the step (ii) may be performed using O₂, CF₄, Ar, N₂, He, SF₄, NF₃ or a mixture thereof.

In an embodiment of the present invention, the plating process in the step (iii) may be an electrolytic plating process performed with a bottom-up filling mechanism.

In an embodiment of the present invention, the metal to be filled inside the hole in the step (iii) may be copper (Cu).

In an embodiment of the present invention, the etchant in the step (iv) may include one or more selected from the group consisting of copper chloride, iron chloride, hydrochloric acid, nitric acid, sulfuric acid, persulfate compounds, and hydrogen peroxide.

### [Advantageous Effects]

According to the method for forming through-via metal wiring of the present invention, through-via metal wiring can be formed with excellent plating quality by a bottom-up filling mechanism without an expensive sputtering process.

### [Description of Drawings]

FIG. 1 is a process cross-sectional view of a conventional method for forming through-via metal wiring.
FIG. 2 is a process cross-sectional view of a method for forming through-via metal wiring according to an embodiment of the present invention.
FIGS. 3A and 3B show measurement results of a cross-section of a glass substrate on which the through-via metal wiring obtained in Example 1 is formed, which is measured by a field emission scanning electron microscope (FE-SEM) measurement method, in which FIG. 3A is a measurement result at 100 magnification and FIG. 3B is a measurement result at 500 magnification.

### [Best Mode]

Hereinafter, the present invention will be described in more detail.

One embodiment of the present invention relates to a method for forming through-via metal wiring.

A method for forming through-via metal wiring according to one embodiment of the present invention includes:
(i) bonding a metal foil to one side of a substrate having a through-via formed therein with an adhesive layer;
(ii) treating a hole formed by the through-via and the metal foil with a plasma to remove the adhesive layer located inside the hole;
(iii) filling the hole with metal by a plating process; and
(iv) removing the metal foil and the adhesive layer with an etchant.

The method for forming through-via metal wiring according to one embodiment of the present invention can form through-via metal wiring with excellent plating quality using a bottom-up filling mechanism without the need for an expensive sputtering process.

The through-via metal wiring forming method according to the present invention is described in detail as follows.

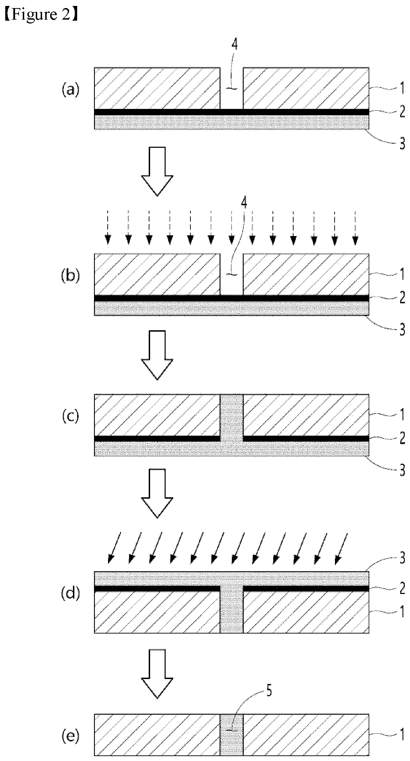

FIG. 2 is a process cross-sectional view of a method for forming through-via metal wiring according to an embodiment of the present invention.

As shown in (a) of FIG. 2, the above step (i) is a step of forming a hole 4 by bonding a metal foil 3 to one side of a substrate 1 having a through-via formed therein with an adhesive layer 2.

The substrate 1 may be a glass substrate, a silicon substrate, a ceramic substrate, or the like, and in particular may be a glass substrate.

The substrate having a through-via formed therein can be manufactured and used by methods known in the art, or commercially available products can be obtained and used.

For example, the glass substrate having a through-via formed therein may be formed by irradiating the glass substrate with a UV or carbon dioxide laser, or by forming microscopic holes in the photosensitive glass substrate and then etching them with hydrofluoric acid, or by drilling the glass substrate with a pair of core drills opposite each other.

The glass substrate may be made of quartz glass, borosilicate glass, aluminosilicate glass, soda-lime glass, titanium-containing silicate glass, or alkali-free glass.

In one embodiment of the present invention, the through-via may have an internal diameter of 2 to 300 µm. In this range of internal diameters, it is possible to form through-via metal wiring with good plating quality.

In one embodiment of the present invention, the thickness of the substrate may be suitably selected according to the application, for example from 100 to 1,000 µm.

The metal foil serves as a seed metal layer for the plating process, and by using it, the sputtering process to form a separate seed metal layer can be omitted.

The metal foil may include one or more selected from the group consisting of copper (Cu), titanium (Ti), iron (Fe), chromium (Cr), aluminum (Al), nickel (Ni) and alloys thereof, and may preferably be a copper foil.

The metal foil may have a thickness of 3 to 1,000 µm, preferably 5 to 100 µm. If the thickness of the metal foil is less than 3 µm, workability may be weak in the process of applying the adhesive and bonding with the substrate, and if it is more than 1,000 µm, uniform bonding with the substrate may be difficult.

The adhesive layer may be formed from one or more selected from the group consisting of an acrylic-based adhesive, a silicone-based adhesive, a polyurethane-based adhesive, and a rubber-based adhesive.

The adhesive layer may be formed by applying and curing the adhesive to one side of the metal foil.

The method of applying the adhesive is not particularly limited, but includes, for example, a spray coat, a bar coat, a gravure coat, a knife coat, an air knife coat, a curtain coat, a die coater, and the like.

The adhesive may be cured by heat or light, and a suitable curing method may be selected depending on the type of adhesive.

If the adhesive is thermally curable, thermal curing can be performed, for example, by heat drying at 40 to 200°C, preferably at 50 to 180°C, even more preferably at 70 to 170°C.

If the adhesive is light-curable, light curing can be performed, for example, by irradiating the adhesive with ultraviolet and/or short-wavelength visible light at an integrated light dose of about 100 to 5000 mJ/cm². In this case, an LED light source, a high-pressure mercury lamp, an ultra-high-pressure mercury lamp, a metal halide lamp, a xenon lamp, and the like are preferably used as the light source.

The adhesive layer may have a thickness of 100 µm or less, preferably 50 µm or less, such as 1 to 100 µm, especially 1 to 50 µm. If the thickness of the adhesive layer is greater than 100 µm, it may be difficult and time-consuming to remove by plasma.

As shown in (b) of FIG. 2, the above step (ii) is a step of treating the hole 4 formed by the through-via and the metal foil with a plasma to remove the adhesive layer, which is an organic material located inside the hole 4, so that the plating process described hereinafter can proceed smoothly.

In the step (ii), the plasma treatment may be carried out using gases such as O₂, CF₄, Ar, N₂, He, SF₄, NF₃ or a mixture thereof.

As shown in (c) of FIG. 2, the above step (iii) is the step of filling the hole 4 with metal by a plating process.

In the step (iii), the plating process may be an electrolytic plating process performed with a bottom-up filling mechanism.

The electrolytic plating process may be performed by applying a current with a current density ranging from 0.5 ASD to 30 ASD (Ampere per Square Decimeter), preferably from 0.5 ASD to 10 ASD. The applied current density may be applied in a particular waveform.

In the step (iii), the metal to be filled inside the hole 4 may be copper (Cu), gold (Au), silver (Ag), titanium (Ti), nickel (Ni), tin (Sn), cobalt (Co), iron (Fe), or an alloy containing at least one component thereof, preferably copper (Cu).

The plating composition used in the electroplating process may include metal salts, strong acids and halogen ion sources.

The metal salt is a metal ion source that is dissociated in the composition to supply metal ions, which may be reduced and precipitated through an electrochemical reaction to fill the interior of the hole.

The metal salts may be suitably selected according to the type of metal to be filled in the hole, for example, inorganic salts, organic salts, oxides, chlorides, etc. of copper (Cu), gold (Au), silver (Ag), titanium (Ti), nickel (Ni), tin (Sn), cobalt (Co), iron (Fe) or alloys containing at least one of these components. If the metal to be filled in the hole is copper (Cu), the metal salt may be copper sulfate, copper nitrate, copper acetate, copper oxide, copper chloride, or the like.

The concentration of the metal salt is not particularly limited, but may be, for example, from 100 to 300 g/L, and preferably from 200 to 250 g/L.

The strong acid, which acts as an electrolyte in addition to adjusting the pH, may be any substance known in the art. Specifically, the strong acid may be one or more selected from the group consisting of sulfuric acid, hydrochloric acid, methanesulfonic acid, ethanesulfonic acid, propanesulfonic acid, trifluoromethanesulfonic acid, sulfonic acid, hydrobromic acid, and fluoroboric acid.

The concentration of the strong acid is not particularly limited, but may be from 50 to 150 g/L, more particularly from 90 to 110 g/L, taking into account the pH of the plating composition and the like.

The halogen ion source is a source of halogen ions in the composition, and can be any substance known in the art. Specifically, the halogen ion source may be a chlorine ion source, for example, hydrochloric acid (HCl).

The concentration of the halogen ion source is not particularly limited, but may be, for example, from 30 to 300 mg/L, and preferably from 40 to 200 mg/L.

Further, the plating composition may further include one or more of a brightener and a carrier.

The brightener is intended to promote plating by increasing the rate of reduction of metal ions, which can be any substance known in the art. Specifically, the brightener may be one or more selected from the group consisting of bis-(3-sulfopropyl)disulfide, sodium salt; 3-mercapto-1-propanesulfonic acid, sodium salt; 3-amino-1-propanesulfonic acid; O-ethyl-S-(3-sulphopropyl) dithiocarbonate, sodium salt; 3-(2-benzthiazolyl-1-thio)-1-propanesulfonic acid, sodium salt; and N,N-dimethyldithiocarbamic acid-(3-sulfopropyl)ester, sodium salt.

The concentration of the brightener is not particularly limited, but may be from 0.5 to 15 ml/L, and more particularly from 1 to 8 ml/L, taking into account the plating speed and the like.

The carrier is intended to increase the surface flatness of the wiring by inhibiting the migration of metal ions and thereby controlling the rate of metal reduction, and any material known in the art may be used. For example, polyethylene glycol, polypropylene glycol, or copolymers thereof may be used as the carrier.

The concentration of the carrier is not particularly limited, but may be, for example, from 1 to 15 ml/L, and preferably from 3 to 12 ml/L.

The plating composition may comprise a residual amount of water. The water may be deionized water.

As shown in (d) of FIG. 2, the above step (iv) is the step of removing the metal foil and the adhesive layer with an etchant.

In step (iv) above, the composition of the etchant may be appropriately selected according to the composition of the metal foil. For example, if the metal film is a copper foil, a conventional copper-based metal film etchant may be used as the etchant.

Specifically, in the step (iv), the etchant may include one or more selected from the group consisting of copper chloride, iron chloride, hydrochloric acid, nitric acid, sulfuric acid, persulfate compounds, and hydrogen peroxide.

The etchant may comprise a residual amount of water.

The method of forming through-via metal wiring according to one embodiment of the invention may further include, after the step (iv), the step (v) of washing the substrate.

The washing may be performed using deionized water.

According to the formation method according to one embodiment of the present invention, a substrate with through-via metal wiring 5 formed with excellent plating quality can be obtained without an expensive sputtering process, as shown in (e) of FIG. 2.

Hereinafter, the present invention will be described in more detail by way of Examples and Experimental Examples. These Examples and Experimental Examples are only for illustrating the present invention, and it is apparent to those skilled in the art that the scope of the present invention is not limited thereto.

### Example 1: Formation of through-via metal wiring

A copper foil with a thickness of 30 µm was bonded to one side of a glass substrate with a thickness of 130 µm having a through-via with an inner diameter of 80 µm using an acrylic-based adhesive layer (ATL-30, Samwon) with a thickness of 2 µm.

The other side of the glass substrate was plasma treated with O₂ gas to remove the adhesive layer located inside the glass hole.

Inside the glass hole, an electrolytic plating process was performed using a plating composition including copper sulfate 230 g/L, sulfuric acid 105.7 g/L, hydrochloric acid 176 mg/L, bis-(3-sulfopropyl) disulfide, sodium salt 6 ml/L, polyethylene glycol 4 ml/L, and a residual amount of deionized water to fill the inside of the glass hole.

On the copper foil side of the glass substrate after the above plating process was completed, an etchant including 5 wt% sulfuric acid, 10 wt% hydrogen peroxide, and a residual amount of deionized water was spray treated to remove the copper foil and the adhesive layer to obtain a glass substrate with through-via metal wiring formed.

### Experimental Example 1: Cross-sectional analysis of through-via metal wiring

The cross-section of the glass substrate in which the through-via metal wiring obtained in Example 1 above was formed was measured by field emission scanning electron microscopy (FE-SEM) to confirm the plating quality.

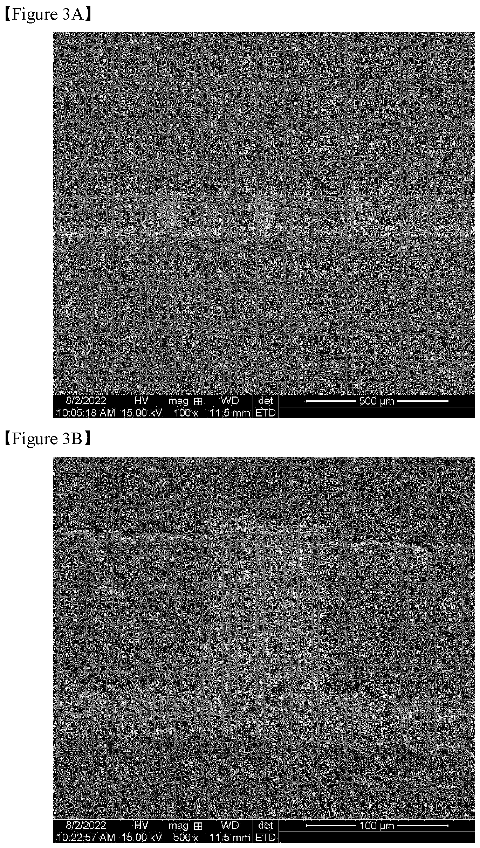

FIGS. 3A and 3B show measurement results, in which FIG. 3A is a measurement result at 100 magnification and FIG. 3B is a measurement result at 500 magnification.

From FIGS. 3A and 3B, it can be seen that through-via metal wiring can be formed with excellent plating quality without gap defects (voids) or boundary defects (seams) according to the method of forming through-via metal wiring of the present invention.

The preferred embodiments of the present invention have been described with reference to the drawings. However, the present invention is not limited to the above-described embodiment, and it will be understood that the present invention can be implemented in a modified form without departing from the essential characteristics of the present invention.

Therefore, the scope of the present invention is defined by the claims rather than the foregoing description, and all differences within the equivalent range should be interpreted as being included in the present invention.

### [Description of reference numerals]

| | | | |
|---|---|---|---|
| 1: | substrate | 2: | adhesive layer |
| 3: | metal foil | 4: | hole |
| 5: | through-via metal wiring | | |

## Claims

1. A method for forming through-via metal wiring comprising:
(i) bonding a metal foil to one side of a substrate having a through-via formed therein with an adhesive layer;
(ii) treating a hole formed by the through-via and the metal foil with a plasma to remove the adhesive layer located inside the hole;
(iii) filling the hole with metal by a plating process; and
(iv) removing the metal foil and the adhesive layer with an etchant.

2. The method for forming through-via metal wiring of claim 1, further comprising (v) washing the substrate, after the step (iv).

3. The method for forming through-via metal wiring of claim 1, wherein the substrate is a glass substrate, a silicon substrate, or a ceramic substrate.

4. The method for forming through-via metal wiring of claim 1, wherein the metal foil is a copper foil.

5. The method for forming through-via metal wiring of claim 1, wherein the metal foil has a thickness of 3 to 1,000 µm.

6. The method for forming through-via metal wiring of claim 1, wherein the adhesive layer is formed from one or more selected from the group consisting of an acrylic-based adhesive, a silicone-based adhesive, a polyurethane-based adhesive, and a rubber-based adhesive.

7. The method for forming through-via metal wiring of claim 1, wherein the plasma treatment in the step (ii) is performed using O₂, CF₄, Ar, N₂, He, SF₄, NF₃ or a mixture thereof.

8. The method for forming through-via metal wiring of claim 1, wherein the plating process in the step (iii) is an electrolytic plating process performed with a bottom-up filling mechanism.

9. The method for forming through-via metal wiring of claim 1, wherein the metal to be filled inside the hole in the step (iii) is copper (Cu).

10. The method for forming through-via metal wiring of claim 1, wherein the etchant in the step (iv) comprises one or more selected from the group consisting of copper chloride, iron chloride, hydrochloric acid, nitric acid, sulfuric acid, persulfate compounds, and hydrogen peroxide.
